# EUROPÄISCHE PATENTSCHRIFT

(11) **EP 2 332 192 B1**
(45) Veröffentlichungstag und Bekanntmachung des Hinweises auf die Patenterteilung: **16.12.2015**
(21) Anmeldenummer: 09783696.9
(22) Anmeldetag: 02.10.2009
(51) Int. Cl.: H01L 41/047, H01L 41/083

(54) **PIEZOAKTOR MIT AUSSENELEKTRODE**
PIEZOACTUATOR WITH AN EXTERNAL ELECTRODE
ACTIONNEUR PIÉZOÉLECTRIQUE COMPRENANT UNE ÉLECTRODE EXTÉRIEURE

(30) Priorität: 06.10.2008 DE 102008050539
(43) Veröffentlichungstag der Anmeldung: 15.06.2011
(73) Patentinhaber: Epcos AG, 81669 München (DE)
(72) Erfinder: BRANTWEINER, Stefan, A-8524 Bad Gams (AT); FELLNER, Siegfried, A-8413 St. Georgen (AT)
(74) Vertreter: Epping - Hermann - Fischer
(86) Internationale Anmeldenummer: PCT/EP2009/062835
(87) Internationale Veröffentlichungsnummer: WO 2010/040693

(56) Entgegenhaltungen:
- WO-A-2004/004021
- WO-A-2005/035971
- WO-A-2005/047689
- WO-A-2005/124884
- DE-A1- 10 259 949
- DE-A1-102004 031 404
- DE-A1-102006 032 743

## Beschreibung

Es wird ein Piezoaktor in Vielschichtbauweise angegeben, der aus einer Vielzahl piezoelektrischer Schichten mit dazwischen liegenden Elektrodenschichten aufgebaut ist. Beim Anlegen einer elektrischen Spannung an die Elektrodenschichten dehnen sich die piezoelektrischen Schichten aus, wodurch ein Hub erzeugt wird. Derartige Piezoaktoren werden beispielsweise zur Betätigung eines Einspritzventils in einem Kraftfahrzeug eingesetzt. Für einen zuverlässigen Betrieb des Piezoaktors müssen die Elektrodenschichten sicher elektrisch kontaktiert werden. Zudem gilt es, Kurzschlüsse zwischen Elektrodenschichten unterschiedlicher Polarität zu verhindern.

In den Druckschriften DE 19945933 C1 und WO 2005/035971 A1 werden Piezoaktoren angegeben, bei denen die elektrische Kontaktierung der Innenelektroden mittels einer sogenannten Drahtharfe vorgenommen wird.

Weitere Vorrichtungen nach dem Stand der Technik sind aus den Druckschriften DE 102 59 949 A1, WO 2005 / 124884 A1, WO 2005 / 047689 A1, WO 2004 / 004021 A1, DE 10 2006 032 743 A1 und DE 10 2004 031 404 A1 bekannt.

Es ist eine zu lösende Aufgabe, einen Piezoaktor mit einer Außenelektrode anzugeben, der kostengünstig herzustellen ist und eine hohe Zuverlässigkeit gegenüber Kurzschlüssen aufweist.

Zur Lösung der Aufgabe wird ein Piezoaktor in Vielschichtbauweise mit einem Stapel aus piezoelektrischen Schichten und dazwischen angeordneten Elektrodenschichten wie durch Anspruch 1 definiert angegeben. Die Elektrodenschichten werden über zwei Außenelektroden elektrisch kontaktiert. Wenigstens eine Außenelektrode weist eine Vielzahl von Drähten auf.

Mittels einer derartigen Außenelektrode können die Elektrodenschichten zuverlässig elektrisch kontaktiert werden. Vorzugsweise sind die Drähte in Form einer Drahtharfe angeordnet, d. h. sie sind in einer Reihe angeordnet und verlaufen parallel zueinander. Eine Außenelektrode aus einer Vielzahl von Drähten ist vorzugsweise verformbar, so dass sie wenig anfällig für Risse in der Elektrode ist und darüber hinaus Risse im Piezoaktor gut überbrücken kann. Falls dennoch ein Riss in einem Draht auftreten sollte, so ist die Wahrscheinlichkeit gering, dass sich der Riss in weitere Drähte ausbreitet. Somit kann eine sichere elektrische Kontaktierung gewährleistet werden.

Die Drähte sind in einem Befestigungsbereich an einer ersten Seitenfläche des Stapels befestigt und werden um die Kante des Stapels herumgeführt, die dem Befestigungsbereich am nächsten liegt.

Ein Befestigungsbereich ist ein Bereich der Oberfläche des Stapels, an dem die Drähte fest mit dem Stapel verbunden sind. Beispielsweise sind die Drähte mit einer auf der Stapeloberfläche aufgebrachten Grundmetallisierung verlötet. Der Befestigungsbereich kann sich auch aus mehreren Teilbereichen der Oberfläche zusammensetzen.

Durch das Herumführen der Drähte um eine Kante des Stapels ist die Außenelektrode an die äußere Form des Stapels angepasst. Beispielsweise werden die Drähte um die Längskante des Stapels herumgeführt. Dadurch, dass die Drähte um diejenige Kante des Stapels herumgeführt werden, die dem Befestigungsbereich am nächsten liegt, ist die benötigte Länge der Drähte gering und somit ist diese Ausführungsform besonders kostengünstig.

Die Drähte verlaufen senkrecht zur Stapelrichtung der piezoelektrischen Schichten.

Bei einer derartigen Anordnung ist nur eine geringe Drahtlänge nötig und es können zudem mechanische Spannungen besonders gut ausgeglichen werden. Dehnt sich der Piezoaktor in Stapelrichtung aus, so treten hier keine oder nur geringe mechanische Spannungen in der Außenelektrode auf. Zudem ist beim Auftreten von Rissen senkrecht zur Stapelrichtung die Wahrscheinlichkeit gering, dass hiervon ein Drahtabschnitt der Außenelektrode betroffen ist.

Vorzugsweise sind die Längen der Drähte im Bereich der ersten Seitenfläche kleiner oder gleich der halben Breite der ersten Seitenfläche.

In einer Ausführungsform ist der Befestigungsbereich so gewählt, dass ein Scheuern der Drähte an den Kanten des Stapels vermieden werden kann.

Der Befestigungsbereich grenzt an die nächstliegende Kante an.

In diesem Fall sind die Drähte im Bereich der Kante am Stapel fixiert, so dass sie sich bei einer Ausdehnung des Stapels mit dem Stapel mitbewegen. Somit führen die Drähte im Bereich der Kante keine Relativbewegung zur Kante aus und können dadurch nicht an der Kante scheuern. Ein Scheuern der Drähte am Stapel könnte zu Rissen in den Drähten und zum Ausfall der elektrischen Kontaktierung führen. Zudem kann die betroffene Kante des Stapels beschädigt werden, so dass ein Kurzschluss zwischen den Elektrodenschichten auftreten kann.

Vorzugsweise sind die Drähte im Bereich der ersten Seitenfläche durchgehend mit dem Stapel verbunden.

Auf diese Weise kann eine zuverlässige Anbindung der Außenelektroden an den Stapel erzielt werden.

Vorzugsweise sind die Drähte jenseits der ersten Seitenfläche gebogen, so dass sie zumindest teilweise parallel zu einer an die Kante angrenzenden zweiten Seitenfläche verlaufen.

Durch den parallelen Verlauf der Drähte zur zweiten Seitenfläche ist die Außenelektrode an die äußere Form des Stapels angepasst und somit wird eine platzsparende elektrische Kontaktierung erreicht.

Die Drähte weisen jenseits der Kante einen Abstand zur zweiten Seitenfläche auf. Insbesondere ist es von Vorteil, wenn die Drähte die zweite Seitenfläche nicht berühren.

Dies hat den Vorteil, dass die Drähte nicht an der zweiten Seitenfläche des Piezoaktors scheuern können. Zudem kann eine Weiterkontaktierung zum Beispiel in Form eines Kontaktstiftes zwischen der Außenelektrode und dem Piezoaktor angeordnet werden. Vorzugsweise ist der Kontaktstift vom Stapel beabstandet angeordnet. Auf diese Weise kann ein Verschleiß des Piezoaktors durch eine Reibung des Kontaktstiftes an der Stapeloberfläche vermieden werden.

Vorzugsweise ist der Piezoaktor ein monolithischer Vielschichtaktor, der aus dünnen Folien eines piezoelektrischen Materials, beispielsweise Blei-Zirkonat-Titanat (PZT), hergestellt wird. Zur Bildung der Elektrodenschichten kann mittels eines Siebdruckverfahrens eine Metallpaste, zum Beispiel eine Silber-Palladium-Paste, auf die Folien aufgebracht werden. Die Folien werden anschließend übereinander geschichtet, verpresst und gemeinsam gesintert. Die Elektrodenschichten sind vorzugsweise entlang der Stapelrichtung des Piezoaktors abwechselnd mit zwei Außenelektroden verbunden.

Hierzu sind in einer bevorzugten Ausführungsform die Elektrodenschichten in Stapelrichtung abwechselnd auf einen Bereich einer Seitenfläche herausgeführt und weisen von einem Bereich einer weiteren Seitenfläche einen Abstand auf. Dabei ergeben sich im Stapel inaktive Zonen, in denen sich benachbarte Elektrodenschichten unterschiedlicher Polarität in Stapelrichtung nicht überlappen. Vorzugsweise erstreckt sich eine inaktive Zone in einer Ebene senkrecht zur Stapelrichtung nur über einen Teilbereich einer Seitenfläche, beispielsweise über einen Bereich, der an eine Kante des Stapels angrenzt. Dadurch dass sich die inaktiven Zonen nicht über eine gesamte Seitenfläche, sondern nur über einen Teilbereich einer Seitenfläche erstrecken, können mechanische Spannungen klein gehalten werden.

Zur elektrischen Kontaktierung der Elektrodenschichten können angrenzend an inaktive Zonen leitfähige Schichten auf die Seitenflächen aufgebracht werden, die sich entlang der Stapelrichtung über den Stapel erstrecken. Beispielsweise befinden sich die leitfähigen Schichten bei entsprechender Anordnung der inaktiven Zonen auf zwei gegenüberliegenden Seitenflächen des Stapels und grenzen an zwei diagonal gegenüberliegende Längskanten des Stapels an. Die Drähte einer Außenelektrode können an den leitfähigen Schichten beispielsweise mittels Lötens oder Schweißens befestigt werden. Beispielsweise sind die Drähte mittels einer Lotschicht mit einer leitfähigen Schicht verbunden.

Bei einer alternativen Ausführungsform des Piezoaktors erstrecken sich die Elektrodenschichten über die gesamte Querschnittsfläche des Stapels. Dies hat den Vorteil, dass im Stapel keine inaktiven Zonen ausgebildet sind und somit mechanische Spannungen reduziert werden. In diesem Fall können die Elektrodenschichten entlang der Stapelrichtung des Piezoaktors abwechselnd mit den Außenelektroden unterschiedlicher Polarität verbunden, indem jede Elektrodenschicht separat mit einem Draht einer Außenelektrode elektrisch verbunden wird. Entlang der Stapelrichtung sind dann die Elektrodenschichten abwechselnd mit einem Draht der ersten Außenelektroden und mit einem Draht der zweiten Außenelektrode kontaktiert.

Die Außenelektrode ist an ihrem freien Ende beispielsweise mittels eines Kontaktstiftes elektrisch angeschlossen, der vorzugsweise parallel zur Stapelrichtung ausgerichtet ist.

Somit wird eine besonders platzsparende Kontaktierung des Piezoaktors erreicht. Durch die elektrische Verbindung der Elektrodenschichten und dem Kontaktstift mittels Drähten ist der Kontaktstift vom Piezoaktor ausreichend mechanisch entkoppelt.

Im Folgenden werden der angegebene Piezoaktor und seine vorteilhaften Ausgestaltungen anhand von schematischen und nicht maßstabsgetreuen Figuren erläutert. Es zeigen:
Figur 1A einen Piezoaktor in einer perspektivischen Ansicht, Figur 1B einen Piezoaktor gemäß Figur 1A in einem Querschnitt senkrecht zur Stapelrichtung,
Figur 2A einen Piezoaktor im Schnitt entlang der Stapelrichtung,
Figur 2B eine Ausführungsform für eine Außenkontaktierung eines Piezoaktors im Querschnitt senkrecht zur Stapelrichtung,
Figur 3A einen beispielhaften, nicht zur vorliegenden Erfindung gehörigen Piezoaktor im Schnitt entlang der Stapelrichtung,
Figur 3B eine alternative Ausführungsform für eine Außenkontaktierung eines beispielhaften, nicht zur vorliegenden Erfindung gehörigen Piezoaktors im Querschnitt senkrecht zur Stapelrichtung.

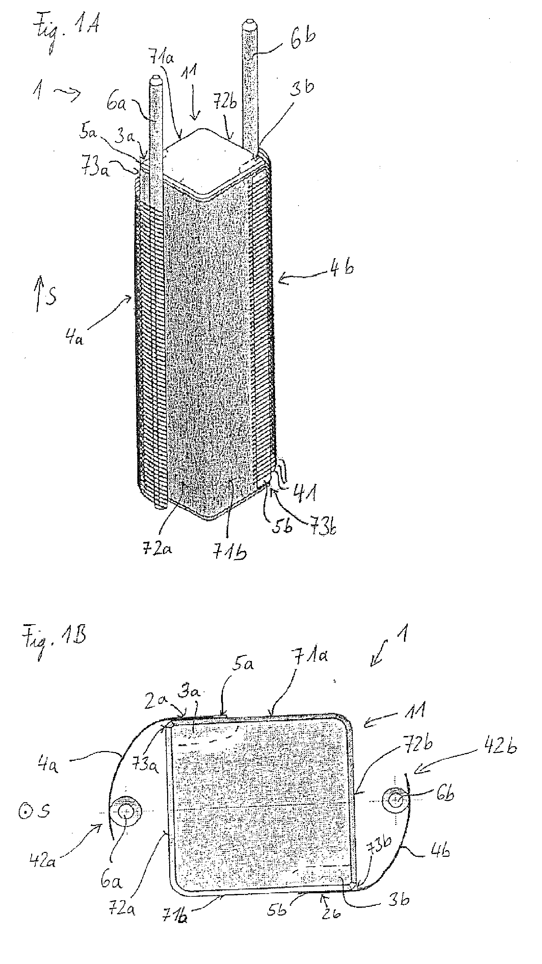

Figur 1A zeigt einen Piezoaktor 1 in Vielschichtbauweise, bei dem eine Vielzahl von piezoelektrischen Schichten und dazwischen liegenden Elektrodenschichten entlang einer Stapelrichtung S zu einem Stapel 11 angeordnet sind. Figur 1B zeigt eine Aufsicht auf einen derartigen Piezoaktor.

Der Stapel 11 weist zwei inaktive Zonen 3a, 3b auf, in denen sich in Stapelrichtung S benachbarte Elektrodenschichten unterschiedlicher Polarität nicht überlappen. Dazu sind die Elektrodenschichten abwechselnd nicht bis auf einen Bereich einer Seitenfläche 71a und einer gegenüberliegenden Seitenfläche 71b herausgeführt. Die inaktiven Zonen 3a, 3b erstrecken sich nur über jeweils einen Teilbereich von zwei ersten Seitenflächen 71a, 71b und reichen jeweils über eine Längskante 73a, 73b des Stapels 11.

Zur elektrischen Kontaktierung der Elektrodenschichten sind auf zwei ersten Seitenflächen 71a, 71b des Stapels 11 streifenförmige leitfähige Schichten 5a, 5b aufgebracht. Die leitfähigen Schichten 5a, 5b sind Grundmetallisierungen, die analog zu den Elektrodenschichten mittels einer Einbrandpaste erzeugt werden. Die leitfähigen Schichten 5a, 5b grenzen an die inaktiven Zonen 3a, 3b an und erstrecken sich über die gesamte Länge des Stapels 11. An jeder leitfähigen Schicht 5a, 5b ist eine Außenelektrode 4a, 4b angelötet.

Jede Außenelektrode 4a, 4b weist eine Vielzahl von Drähten 41 auf, die senkrecht zur Stapelrichtung S verlaufen. Die Drähte 41 sind auf ersten Seitenflächen 71a, 71b in Befestigungsbereichen 2a, 2b an leitfähigen Schichten 5a, 5b befestigt und um die angrenzenden Längskanten 73a, 73b herumgeführt. Die Befestigungsbereiche 2a, 2b grenzen an die nächstliegenden Längskanten 73a, 73b an. Somit kann ein Scheuern der Drähte 41 an den Längskanten 73a, 73b und damit ein Verschleiß durch eine unmittelbare Reibung der Drähte 41 an den Längskanten 73a, 73b verhindert werden. Im Bereich der ersten Seitenfläche 71a, 71b sind die Drähte 41 durchgehend mit dem Stapel 11 verbunden.

Im Bereich einer zweiten Seitenfläche 72a, 72b ist das freie Ende 42a, 42b jeder Außenelektrode 4a, 4b mit einem Kontaktstift 6a, 6b verbunden. Die Kontaktstifte 6a, 6b sind von den zweiten Seitenflächen 72a, 72b beabstandet, so dass ein Scheuern der Kontaktstifte 6a, 6b an den Seitenflächen 72a, 72b verhindert wird.

Die Außenelektroden 5a, 5b sind jeweils um die Längskante 73a, 73b herumgeführt, die an die leitfähige Schicht 5a, 5b auf der jeweils ersten Seitenfläche 71a, 71b angrenzt. Jenseits der Längskante 73a, 73b verlaufen die Drähte 41 zumindest in einem Teilbereich parallel zu einer an die Längskante 73a, 73b angrenzenden zweiten Seitenfläche 72a, 72b und weisen zu der zweiten Seitenfläche 72a, 72b einen Abstand auf. Dadurch wird ein Scheuern der Drähte 51 an den zweiten Seitenflächen 72a, 72b des Piezoaktors 1 verhindert. Das freie Ende 42a, 42b einer Außenelektrode 4a, 4b ist mit einem Kontaktstift 6a, 6b verbunden, der zwischen der jeweiligen Außenelektrode 4a, 4b und der zweiten Seitenfläche 72a, 72b angeordnet ist. Die Kontaktstifte 6a, 6b erstrecken sich entlang der Stapelrichtung. Die Drähte 41 enden auf Höhe der Mitte der jeweiligen zweiten Seitenfläche 72a, 72b.

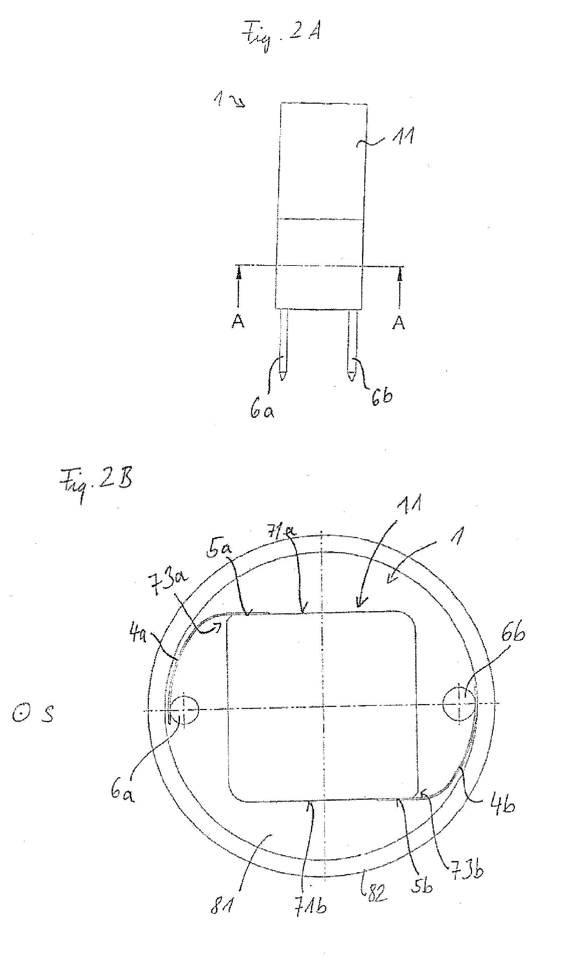

Figur 2B zeigt eine erste Ausführungsform für eine Außenkontaktierung eines Piezoaktors im Querschnitt senkrecht zur Stapelrichtung. Der Querschnitt ist hierbei entlang der in Figur 2A eingezeichneten Linie ausgeführt und in einer Aufsicht entsprechend den mit A gekennzeichneten Pfeilen zu sehen. Der Piezoaktor 1 ist mit einer Vergussmasse 81, z. B. Silikon, vergossen und von einer Kunststoffhülse 82 umgeben. Mittels der Vergussmasse können der Piezoaktor 1 und die Kontaktstifte 6a, 6b in einer gewünschten Position fixiert werden.

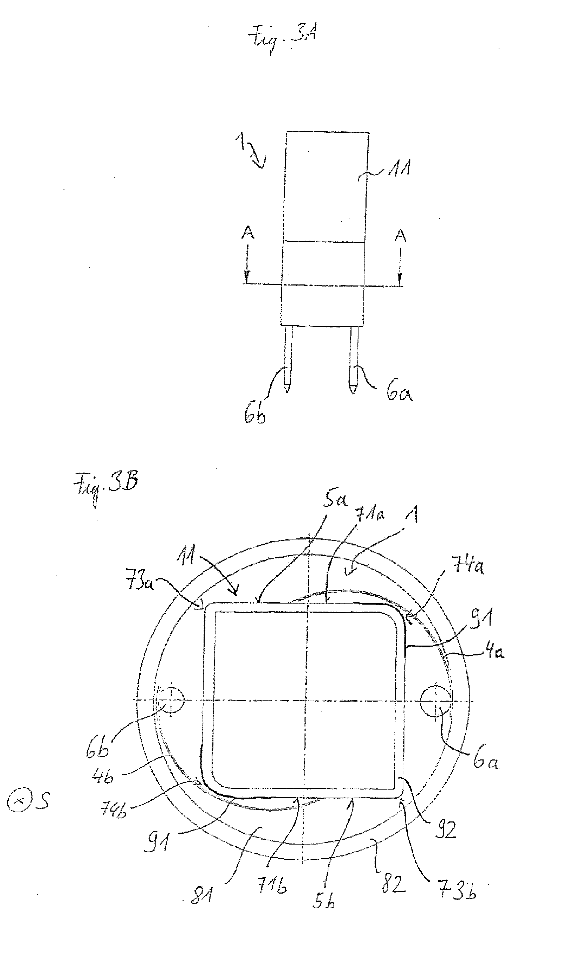

Figur 3B zeigt beispielhaft und außerhalb der vorliegenden Erfindung eine alternative Ausführungsform für eine Außenkontaktierung eines Piezoaktors im Querschnitt senkrecht zur Stapelrichtung S. Der Querschnitt ist hierbei entlang der in Figur 3A eingezeichneten Linie ausgeführt und in einer Aufsicht entsprechend den mit A gekennzeichneten Pfeilen zu sehen.

Bei dieser Ausführungsform sind die Außenelektroden 4a, 4b ebenfalls an leitfähigen Schichten 5a, 5b befestigt, die sich im Bereich von Längskanten 73a, 73b des Stapels 11 befinden. Die Außenelektroden 4a, 4b sind hier jedoch jeweils um diejenige Längskante 74a, 74b herumgeführt, die nicht an die leitfähigen Schichten 5a, 5b angrenzt.

In diesem Fall sind die Außenelektroden 4a, 4b zudem nicht mit der jeweils ersten Seitenfläche 71a, 71b fest verbunden, sondern heben zum Teil von ihr ab. Dies führt dazu, dass sich bei einer Ausdehnung des Stapels die Außenelektroden 4a, 4b im Bereich der ersten Seitenflächen 71a, 71b und der Längskanten 74a, 74b relativ zum Stapel 11 bewegen und so an der Seitenfläche oder einer Kante des Stapels 11 scheuern können. Zum Schutz vor Beschädigungen ist der Stapel 11 an seinen Seitenflächen 71a, 71b, 72a, 72b von einer Passivierungsschicht 92 umgeben. Auf die Längskanten 74a, 74b, um die die Außenelektroden 5a, 5b herumgeführt sind, sind zum Schutz zusätzlich Kaptonfolien 91 aufgebracht.

Im Gegensatz dazu ist in der in Figur 2B gezeigten Ausführungsform keine Passivierungsschicht 92 und keine Kaptonfolie 91 nötig, da hier ein Scheuern der Drähte 41 schon durch die Anordnung der Außenelektroden 4a, 4b auf dem Stapel 11 verhindert werden kann. Zudem ist bei einem Herumführen der Außenelektrode 4a, 4b um die Längskante 73a, 74b, die an die jeweilige leitfähige Schicht 5a, 5b angrenzt, eine kürzere Drahtlänge erforderlich als bei dem in Figur 3B gezeigten Ausführungsbeispiel. Somit ist die in Figur 2B gezeigte Außenkontaktierung besonders kostengünstig.

Die Erfindung ist nicht durch die Beschreibung an Hand der Ausführungsbeispiele auf diese beschränkt, sondern wird durch die Ansprüche definiert.

### Bezugszeichenliste

- 1: Piezoaktor
- 11: Stapel
- 2a, 2b: Befestigungsbereich
- 3a, 3b: Inaktive Zone
- 4a, 4b: Außenelektrode
- 41: Draht
- 42a, 42b: freies Ende
- 5a, 5b: leitfähige Schicht
- 6a, 6b: Kontaktstift
- 71a, 71b: erste Seitenfläche
- 72a, 72b: zweite Seitenfläche
- 73a, 73b, 74a, 74b: Längskante
- 81: Vergussmasse
- 82: Kunststoffhülse
- 91: Kaptonfolie
- 92: Passivierungsschicht

- S: Stapelrichtung

## Patentansprüche

1. Piezoaktor in Vielschichtbauweise
- mit einem Stapel (11) aus piezoelektrischen Schichten und dazwischen angeordneten Elektrodenschichten,
- mit zwei Außenelektroden (4a, 4b) zur elektrischen Kontaktierung der Elektrodenschichten,
- bei dem wenigstens eine Außenelektrode (4a, 4b) eine Vielzahl von Drähten (41) aufweist,
- wobei die Drähte (41) in einem Befestigungsbereich (2a, 2b) an einer ersten Seitenfläche (71a, 71b) des Stapels (11) befestigt sind, und um die dem Befestigungsbereich (2a, 2b) nächstliegende Kante (73a, 73b) des Stapels (11) herumgeführt sind, und wobei die Drähte (41) jenseits der Kante (73a, 73b) einen Abstand zur zweiten Seitenfläche (72a, 72b) aufweisen,
- bei dem der Stapel (11) eine Stapelrichtung (S) aufweist, und die Drähte (41) senkrecht zur Stapelrichtung (S) verlaufen,
- **dadurch gekennzeichnet, dass** die Drähte (41) im Befestigungsbereich (2a, 2b) durchgehend bis zur dem Befestigungsbereich (2a, 2b) nächstliegenden Kante (73a, 73b) mit dem Stapel (11) verbunden sind.

2. Piezoaktor nach Anspruch 1, bei dem die Drähte (41) in Form einer Drahtharfe angeordnet sind.

3. Piezoaktor nach Anspruch 2,
- bei dem die Längen der Drähte (41) im Bereich der ersten Seitenfläche (71a, 71b) kleiner oder gleich der halben Breite der ersten Seitenfläche (71a, 71b) sind.

4. Piezoaktor nach einem der Ansprüche 1 bis 3,
- bei dem der Befestigungsbereich (2a, 2b) an die nächstliegende Kante (73a, 73b) angrenzt.

5. Piezoaktor nach einem der Ansprüche 1 bis 4,
- bei dem die Drähte (41) jenseits der ersten Seitenfläche (71a, 71b) gebogen sind, so dass sie zumindest teilweise parallel zu einer an die Kante (73a, 73b) angrenzenden zweiten Seitenfläche (72a, 72b) verlaufen.

6. Piezoaktor nach einem der Ansprüche 1 bis 5,
- bei dem die Drähte (4a, 4b) auf Höhe der Mitte der zweiten Seitenfläche (72a, 72b) enden.

7. Piezoaktor nach einem der Ansprüche 1 bis 6,
- bei dem das freie Ende (42a, 42b) der Außenelektrode (4a, 4b) mit einem Kontaktstift (6a, 6b) verbunden ist, der parallel zur Stapelrichtung (S) ausgerichtet ist.

8. Piezoaktor nach einem der Ansprüche 1 bis 7,
- bei dem die Drähte (41) an einer streifenförmigen leitfähigen Schicht (5a, 5b) befestigt sind, die sich entlang der Stapelrichtung (S) über den Stapel (11) erstreckt.

9. Piezoaktor nach Anspruch 8,
- bei dem die Drähte (41) mittels einer Lotschicht mit der leitfähigen Schicht (5a, 5b) verbunden sind.

10. Piezoaktor nach einem der Ansprüche 8 oder 9,
- mit zwei streifenförmigen leitfähigen Schichten (5a, 5b),
- bei dem die Elektrodenschichten entlang der Stapelrichtung (S) abwechselnd mit einer der leitfähigen Schichten (5a, 5b) elektrisch verbunden sind.

11. Piezoaktor nach einem der vorhergehenden Ansprüche,
- der mit einer Vergussmasse (81) vergossen ist.

12. Piezoaktor nach einem der vorhergehenden Ansprüche,
- der durch gemeinsame Sinterung aller Schichten des Stapels (11) hergestellt ist.

13. Piezoaktor nach einem der Ansprüche 9 bis 12,
- der gemäß Anspruch 7 ausgebildet ist,
- bei dem der Kontaktstift (6a, 6b) vom Stapel (11) beabstandet angeordnet ist.

## Claims

1. Piezoelectric actuator of a multilayer design
- with a stack (11) of piezoelectric layers and electrode layers arranged in between
- with two outer electrodes (4a, 4b) for the electrical contacting of the electrode layers,
- in which at least one outer electrode (4a, 4b) has a multiplicity of wires (41),
- wherein the wires (41) are fastened in a fastening region (2a, 2b) on a first side face (71a, 71b) of the stack (11), and are led around the edge (73a, 73b) of the stack (11) that lies closest to the fastening region (2a, 2b), and wherein, beyond the edge (73a, 73b), the wires (41) are at a distance from the second side face (72a, 72b),
- in which the stack (11) has a stacking direction (S), and the wires (41) run perpendicularly to the stacking direction (S),
- **characterized in that**, in the fastening region (2a, 2b), the wires (41) are connected to the stack (11) throughout up to the edge (73a, 73b) that lies closest to the fastening region (2a, 2b).

2. Piezoelectric actuator according to Claim 1, in which the wires (41) are arranged in the form of a wire harp.

3. Piezolectric actuator according to Claim 2,
- in which the lengths of the wires (41) in the region of the first side face (71a, 71b) are less than or equal to half the width of the first side face (71a, 71b).

4. Piezolectric actuator according to one of Claims 1 to 3,
- in which the fastening region (2a, 2b) is adjacent to the closest edge (73a, 73b).

5. Piezolectric actuator according to one of Claims 1 to 4,
- in which, beyond the first side face (71a, 71b), the wires (41) are bent, so that they run at least partially parallel to a second side face (72a, 72b) that is adjacent to the edge (73a, 73b).

6. Piezolectric actuator according to one of Claims 1 to 5,
- in which the wires (4a, 4b) end at the level of the middle of the second side face (72a, 72b).

7. Piezolectric actuator according to one of Claims 1 to 6,
- in which the free end (42a, 42b) of the outer electrode (4a, 4b) is connected to a contact pin (6a, 6b), which is aligned parallel to the stacking direction (S).

8. Piezolectric actuator according to one of Claims 1 to 7,
- in which the wires (41) are fastened to a conductive layer (5a, 5b) in strip form, which extends over the stack (11) along the stacking direction (S).

9. Piezolectric actuator according to Claim 8,
- in which the wires (41) are connected to the conductive layer (5a, 5b) by means of a layer of solder.

10. Piezolectric actuator according to either of Claims 8 and 9,
- with two conductive layers (5a, 5b) in strip form,
- in which the electrode layers are electrically connected to one of the conductive layers (5a, 5b) in an alternating manner along the stacking direction (S).

11. Piezolectric actuator according to one of the preceding claims,
- which is cast with a casting compound (81).

12. Piezolectric actuator according to one of the preceding claims,
- which is produced by sintering all the layers of the stack (11) at one and the same time.

13. Piezolectric actuator according to one of Claims 9 to 12,
- which is formed according to Claim 7,
- in which the contact pin (6a, 6b) is arranged at a distance from the stack (11).

## Revendications

1. Piézoactionneur à structure multicouche, présentant
une pile (11) de couches piézoélectriques entre lesquelles sont disposées des couches d'électrode,
deux électrodes extérieures (4a, 4b) qui assurent la mise en contact électrique des couches d'électrode,
au moins une électrode extérieure (4a, 4b) présentant plusieurs fils (41),
les fils (41) étant fixés dans une partie de fixation (2a, 2b) sur une première surface latérale (71a, 71b) de la pile (11) et contournant le bord (73a, 73b) de la pile (11) le plus proche de la partie de fixation (2a, 2b),
les fils (41) présentant de chaque côté du bord (73a, 73b) une distance par rapport à la deuxième surface latérale (72a, 72b),
la pile (11) présentant une direction (S) d'empilement et les fils (41) s'étendant perpendiculairement à la direction (S) d'empilement,
**caractérisé en ce que**
les fils (41) sont reliés à la pile (11) dans la partie de fixation (2a, 2b) de manière continue jusqu'au bord (73a, 73b) la plus proche de la partie de fixation (2a, 2b).

2. Piézoactionneur selon la revendication 1, dans lequel les fils (41) sont disposés en forme de harpe de fils.

3. Piézoactionneur selon la revendication 2, dans lequel la longueur des fils (41) au niveau de la première surface latérale (71a, 71b) est inférieure ou égale à la moitié de la largeur de la première surface latérale (71a, 71b).

4. Piézoactionneur selon l'une des revendications 1 à 3, dans lequel la partie de fixation (2a, 2b) est adjacente au bord le plus proche (73a, 73b).

5. Piézoactionneur selon l'une des revendications 1 à 4, dans lequel les fils (41) sont courbés de chaque côté de la première surface latérale (71a, 71b) de telle sorte qu'ils s'étendent au moins en partie parallèlement à une deuxième surface latérale (72a, 72b) adjacente au bord (73a, 73b).

6. Piézoactionneur selon l'une des revendications 1 à 5, dans lequel les fils (4a, 4b) se terminent à hauteur du milieu de la deuxième surface latérale (72a, 72b).

7. Piézoactionneur selon l'une des revendications 1 à 6, dans lequel l'extrémité libre (42a, 42b) de l'électrode extérieure (4a, 4b) est reliée à une tige de contact (6a, 6b) alignée parallèlement à la direction d'empilement (S).

8. Piézoactionneur selon l'une des revendications 1 à 7, dans lequel les fils (41) sont fixés sur une couche conductrice (5a, 5b) en forme de ruban qui s'étend au-dessus de la pile (11) dans la direction d'empilement (S).

9. Piézoactionneur selon la revendication 8, dans lequel les fils (41) sont reliés à la couche conductrice (5a, 5b) au moyen d'une couche de brasure.

10. Piézoactionneur selon l'une des revendications 8 ou 9, présentant deux couches conductrices (5a, 5b) en forme de ruban et dans lequel les couches d'électrode sont reliées électriquement à l'une des couches conductrices (5a, 5b) en alternance dans la direction d'empilement (S).

11. Piézoactionneur selon l'une des revendications précédentes, englobé dans une pâte de coulée (81).

12. Piézoactionneur selon l'une des revendications précédentes, réalisé par frittage conjoint de toutes les couches de la pile (11).

13. Piézoactionneur selon l'une des revendications 9 à 12, configuré selon la revendication 7 et dans lequel la tige de contact (6a, 6b) est disposée à distance de la pile (11).
